# EUROPEAN PATENT APPLICATION

(11) **EP 4 362 055 A2**
(43) Date of publication of application: **01.05.2024**
(21) Application number: 23197630.9
(22) Date of filing: 15.09.2023
(51) Int. Cl.: H01J 37/141, H01J 37/153, H01J 37/28

(54) **ELECTRON MICROSCOPE, MULTIPOLE ELEMENT FOR USE THEREIN, AND CONTROL METHOD FOR SUCH ELECTRON MICROSCOPE**

(30) Priority: 31.10.2022 JP 2022174716
(71) Applicant: Jeol Ltd., Akishima-shi, Tokyo 196-8558 (JP)
(72) Inventor: MORISHITA, Shigeyuki, Tokyo, 196-8558 (JP); JIMBO, Yu, Tokyo, 196-8558 (JP)
(74) Representative: Boult Wade Tennant LLP

(57) **Abstract**

There is provided an electron microscope capable of reducing variations of aberrations due to thermal variations. The electron microscope (100) includes an electron optical system (2) having a built-in aberration corrector (26) equipped with multipole elements (260) each for producing a multipolar field. Each multipole element (260) includes a plurality of magnetic polepieces (4). Each polepiece (4) includes a magnetic core (6), a first coil (8a) wound around the core (6), and a second coil (8b) wound around the core (6). The first coil (8a) and the second coil (8b) produce a first multipolar field and a second multipolar field, respectively, when energized. The first and second multipolar fields are identical in terms of symmetry.

## Description

### BACKGROUND OF THE INVENTION

### 1. Field of the Invention

The present invention relates to an electron microscope and a control method therefor. The invention also relates to a multipole element used in such an electron microscope.

### 2. Description of the Related Art

In an electron microscope (such as a transmission electron microscope (TEM), a scanning transmission electron microscope (STEM), or a scanning electron microscope (SEM)), aberration correction is an important technique in acquiring high-resolution images.

For example, patent document 1 discloses a two-stage hexapole field type spherical aberration corrector having two stages of hexapole elements each of which produces a hexapole field. In this spherical aberration corrector, positive spherical aberration in an objective lens is corrected by negative spherical aberrations produced respectively by the two stages of hexapole elements.

A multipole element has a plurality of magnetic polepieces each of which includes a magnetic core and a coil wound around the core. The multipole element is made to produce a multipolar field by supplying an energization current to the coil.

In a scanning transmission electron microscope, the electron optical system is operated in various modes according to purposes. For example, in a mode of operation for acquiring a high-resolution STEM image, aberrations in the illumination optics are corrected by an aberration corrector.

In a differential phase contrast (DPC) method, the amount of deflection of an electron beam caused by the electromagnetic field within a sample is measured and the electromagnetic field is visualized. In a diffraction imaging method, a sample image is reconstructed from a diffraction pattern of the sample. When such a method is implemented, there is used an optical mode in which a small angle of convergence can be achieved. In this mode, aberrations are not corrected by the aberration corrector for the following reason. In an optical system where small angles of convergence occur, if a multipolar field is produced, large amounts of undesired aberrations arise, thus deteriorating the resolution.

### Citation List

### Patent Documents

Patent document 1: JP-A-2003-92078

If a switch is made from an optical mode in which aberrations are not corrected by the aberration corrector to an optical mode in which the aberrations are corrected by the aberration corrector, each multipole element of the aberration corrector is switched from an inoperative mode in which no multipolar field is produced to an operative mode in which a multipolar field is produced. Consequently, energization currents flow through the coils, thus bringing about great variations in the temperatures of the multipole elements. This in turn varies aberrations arising from the aberration corrector. Hence, it has been impossible to perform an observation or analysis from when the optical mode is switched until fluctuations of aberrations settle down.

### SUMMARY OF THE INVENTION

One aspect of the electron microscope associated with the present invention comprises an electron optical system having a built-in aberration corrector equipped with multipole elements each for producing a multipolar field. Each of the multipole elements includes a plurality of magnetic polepieces. Each of the magnetic polepieces includes a magnetic core, a first coil wound around the core, and a second coil wound around the core. The first and second coils produce a first multipolar field and a second multipolar field, respectively, when energized. The first and second multipolar fields are identical in terms of symmetry.

In this electron microscope, the first and second multipolar fields can be made to cancel out each other by orienting the first and second multipolar fields in opposite senses. Therefore, activation and deactivation of the multipolar field from each multipole element can be controlled by varying the sense of the magnetic field produced by the second or first coil. Consequently, the amount of heat of the multipole element in the presence of the multipolar field can be made equal to the amount of heat of the multipole element in the absence of the multipolar field. Thus, when a switch is made in this electron microscope between the non-correcting optical mode in which aberrations are not corrected by the aberration corrector and the aberration correcting optical mode in which aberrations are corrected by the aberration corrector, there occur less aberration variations.

One aspect of the multipole element associated with the present invention comprises a plurality of magnetic polepieces for producing a multipolar field. Each of the magnetic polepieces includes a magnetic core, a first coil wound around the core, and a second coil wound around the core. The first and second coils produce a first multipolar field and a second multipolar field, respectively, when energized. The first and second multipolar fields are identical in terms of symmetry.

With this multipole element, the first and second multipolar fields can be made to cancel out each other by orienting the first and second multipolar fields in opposite senses. Therefore, activation and deactivation of the multipolar field from each multipole element can be controlled by varying the sense of the magnetic field produced by the second or first coil. Consequently, with this multipole element, the amount of heat generated when the multipolar field is activated can be made equal to the amount of heat generated when the multipolar field is deactivated.

One aspect of the control method associated with the present invention is for use in controlling an electron microscope comprising an electron optical system having a built-in aberration corrector equipped with multipole elements each for producing a multipolar field. The control method comprises the steps of: operating the electron optical system in a first optical mode in which aberrations are not corrected by the aberration corrector; and making a switch from the first optical mode to a second optical mode in which aberrations are corrected by the aberration corrector and operating the electron optical system. Each of the multipole elements includes a plurality of magnetic polepieces. Each of the magnetic polepieces includes a magnetic core, a first coil wound around the core, and a second coil wound around the core. The first and second coils produce a first multipolar field and a second multipolar field, respectively, when energized. The first and second multipolar fields are identical in terms of symmetry. Each of the multipole elements has an inoperative mode and an operative mode. In the inoperative mode, no multipolar field is produced by causing the magnetic fields generated by the first and second coils, respectively, to be oriented in opposite senses. In the operative mode, a multipolar field is produced by causing the magnetic fields respectively produced by the first and second coils to be oriented in the same sense. In the step of making a switch from the first optical mode to the second optical mode, the multipole element is switched from the inoperative mode to the operative mode.

This control method for the electron microscope involves the step of making a switch from the first optical mode to the second optical mode. In this step, the multipole element is switched from the inoperative mode, in which no multipolar field is produced from the multipole element by causing the magnetic fields respectively generated by the first and second coils to be oriented in opposite senses, to the operative mode, in which the magnetic fields respectively generated by the first and second coils are oriented in the same sense such that a multipolar field is produced from the multipole element. Consequently, there occur less aberration variations when a switch is made from the first to the second optical mode.

### BRIEF DESCRIPTION OF THE DRAWINGS

FIG. 1 is a diagram showing the configuration of an electron microscope associated with one embodiment of the present invention.
FIG. 2 is a schematic diagram of the sensitive surface of a segmented detector.
FIG. 3 is a diagram illustrating the configuration of illumination optics.
FIG. 4 is a schematic diagram of one multipole element.
FIG. 5 is a schematic diagram of one magnetic polepiece.
FIG. 6 is a schematic diagram of a modification of the magnetic polepiece of FIG. 5.
FIG. 7 is a diagram similar to FIG. 4, but illustrating one operative mode of the multipole element.
FIG. 8 is a diagram similar to FIG. 7, but illustrating the other operative mode of the multipole element.
FIG. 9 is an electron ray diagram illustrating one example of the optical mode of an electron optical system.
FIG. 10 is an electron ray diagram illustrating another example of the optical mode of the electron optical system.
FIG. 11 is a flowchart illustrating one example of processing sequence performed by a controller to control the electron optical system.
FIG. 12 is a diagram illustrating the operative modes of a conventional multipole element.
FIG. 13 is an electron ray diagram illustrating a further example of the optical mode of the electron optical system.
FIG. 14 is a schematic cross-sectional view of one collector lens.

### DETAILED DESCRIPTION OF THE INVENTION

The preferred embodiments of the present invention are hereinafter described in detail with reference to the drawings. It is to be understood that the embodiments set forth below are not intended to unduly restrict the content of the present invention delineated by the claims and that not all the configurations set forth hereinafter are essential constituent components of the present invention.

### 1. Electron Microscope

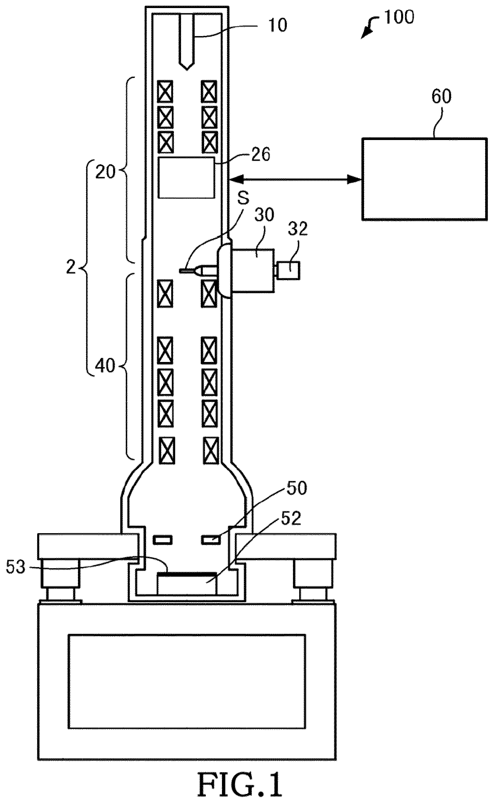

First, an electron microscope associated with one embodiment of the present invention is described by referring to FIG. 1, which shows the configuration of the electron microscope, 100.

As shown, the electron microscope 100 includes an electron source 10, an electron optical system 2, a sample stage 30, an STEM detector 50, a segmented detector 52, and a controller 60. The electron optical system 2 includes illumination optics 20 and imaging optics 40. The electron microscope 100 is a scanning transmission electron microscope (STEM) having an aberration corrector 26 incorporated in the illumination optics 20.

The electron source 10 which emits an electron beam is an electron gun, for example, that emits the electron beam by accelerating electrons with an anode after the electrons are released from a cathode. The electron optical system 2 includes the illumination optics 20 and the imaging optics 40 as mentioned above. The electron beam emitted from the electron source 10 is directed at a sample S through the illumination optics 20 which, for example, focuses the electron beam from the electron source 10 into an electron probe that scans the sample S. The imaging optics 40 images the electrons transmitted through the sample S. The electron beam transmitted through the sample S is passed onto the STEM detector 50 and onto the segmented detector 52 via the imaging optics 40.

The STEM detector 50 detects electrons transmitted through the sample S. For example, the STEM detector 50 is a dark-field STEM detector using an annular detector for detecting electrons inelastically scattered through high angles from the sample S.

The segmented detector 52 has an electron sensitive surface 53 for detecting the electrons transmitted through the sample S, the sensitive surface 53 being split into a plurality of detector segments.

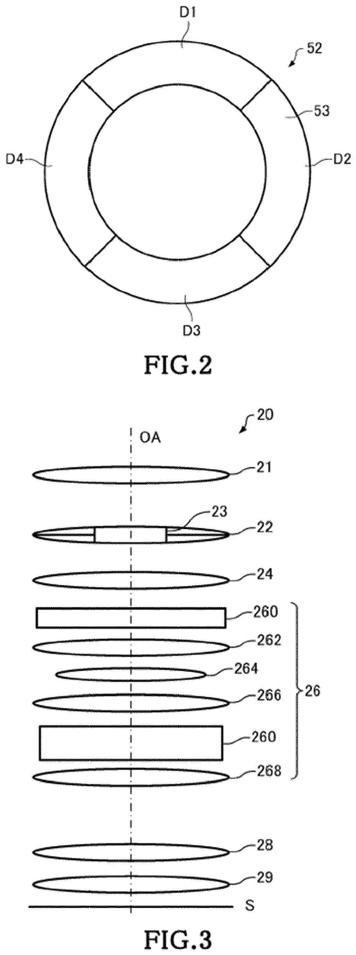

FIG. 2 schematically shows the sensitive surface 53 of the segmented detector 52. As shown, the sensitive surface 53 is divided into detector segments D1, D2, D3, and D4 which are formed by angularly (circumferentially) quartering the annular sensitive surface 53 of the segmented detector 52. Each of the four detector segments D1-D4 can independently detect electrons.

Note that there is no restriction on the number of the detector segments of the sensitive surface 53. That is, the segmented detector 52 may have a plurality of detector segments which are separated from each other radially and circumferentially in a manner not illustrated. For example, the sensitive surface 53 of the segmented detector 52 may have 16 detector segments by being radially divided by 4 and circumferentially divided by 4.

The segmented detector 52 includes, for example, an electron-to-light converter (scintillator) for converting electrons into light, light transmission paths (consisting of a bundle of optical fibers) for separating the electron-to-light converter into the detector segments D1, D2, D3, and D4 and transmitting light signals from the detector segments D1-D4, and a plurality of optical detectors (photoelectron multipliers) for producing detection signals responsive to the electron intensities respectively detected by the detector segments D1-D4. The segmented detector 52 may be a semiconductor detector having a plurality of detector segments. The sample stage 30 mechanically supports the sample S held to a sample holder 32 and permits the sample S to be placed in position.

The controller 60 includes a processor (such as a CPU (central processing unit)) and storage devices (such as a RAM (random access memory) and a ROM (read-only memory)). Programs and data for carrying out various control operations are stored in the storage devices. The functions of the controller 60 can be implemented by executing programs by means of the processor. The controller 60 controls various parts of the electron microscope 100 via driver circuitry (not shown).

FIG. 3 illustrates the configuration of the illumination optics 20. As shown, the illumination optics 20 includes a first condenser lens 21, a second condenser lens 22, a condenser aperture 23, a third condenser lens 24, the above-described aberration corrector 26, and a condenser minilens 28. The illumination optics 20 further includes a front magnetic field 29 produced in front of the sample S by the objective lens.

The first condenser lens 21, second condenser lens 22, and third condenser lens 24 are arranged in this order from a side of the electron source 10. These three condenser lenses 21, 22, and 24 together converge an electron beam. The condenser aperture 23 is placed within the second condenser lens 22.

The aberration corrector 26 is disposed between the third condenser lens 24 and the condenser minilens 28. The aberration corrector 26 is incorporated in the illumination optics 20, and is a spherical aberration corrector for correcting spherical aberration in the illumination optics 20. The aberration corrector 26 includes two stages of multipole elements 260, a first collector lens 262, a second collector lens 264, a third collector lens 266, and a fourth collector lens 268. The aberration corrector 26 is a two-stage hexapole spherical aberration corrector having the two stages of multipole elements 260.

Each multipole element 260 produces a hexapolar magnetic field of three-fold symmetry. For example, each multipole element 260 is a hexapole element, a dodecapole element, or any other multipole element capable of generating a hexapolar magnetic field.

The first collector lens 262, second collector lens 264, and third collector lens 266 are placed between the first stage of multipole element 260 and the second stage of multipole element 260. These three collector lenses 262, 264, and 266 together constitute transfer optics for transferring the principal optical plane of the first stage of multipole element 260 to the principal optical plane of the second stage of multipole element 260. This transfer optics transfers an image equivalent to the output image of the first stage of multipole element 260 to the second stage of multipole element 260. The second collector lens 264 is positioned between the first collector lens 262 and the third collector lens 266. The second collector lens 264 imparts a rotary action to the electron beam without applying a light focusing action to the beam. Consequently, the rotation occurring between the first stage of multipole element 260 and the second stage of multipole element 260 relative to the electron orbit can be corrected. The fourth collector lens 268 is disposed between the second stage of multipole element 260 and the condenser minilens 28 and serves as a transfer lens.

Each multipole element 260 has a thickness in the direction of travel of the electron beam, i.e., along the optical axis OA. That is, the multipole element 260 produces a negative spherical aberration as a combination aberration of three-fold astigmatisms in a hexapolar field having a thickness. The combination aberration referred to herein is a combination of aberrations 1 and 2 when the aberration 1 occurs at some location, propagates a distance, thereby varies the point of incidence, and is affected by the other aberration 2.

Positive spherical aberration in the illumination optics 20 can be corrected by negative spherical aberrations respectively produced by the first stage of multipole element 260 and the second stage of multipole element 260.

The three-fold astigmatism produced by the second stage of multipole element 260 is opposite in sense to the three-fold astigmatism produced by the first stage of multipole element 260. Therefore, the three-fold astigmatism produced by the first stage of multipole element 260 can be canceled out by the three-fold astigmatism produced by the second stage of multipole element 260.

There are no restrictions on the aberration corrector 26 as long as it can correct aberrations using the multipole elements 260. The aberration corrector 26 may also be of the three-stage, hexapolar field type.

The condenser minilens 28 is located between the aberration corrector 26 and the magnetic field 29 produced forwardly of the objective lens, and is operative to create an electron beam having a convergence angle adapted for the optical mode. The convergence angle can be varied by varying the excitation of the condenser minilens 28. The magnetic field 29 produced forwardly of the objective lens functions as a condenser lens for converging an electron beam.

The illumination optics 20 includes a scan deflector (not shown) for deflecting the electron beam in two dimensions. The scan deflector permits the sample S to be scanned with the electron beam.

### 2. Multipole Elements

### 2.1. Configuration of Multipole Elements

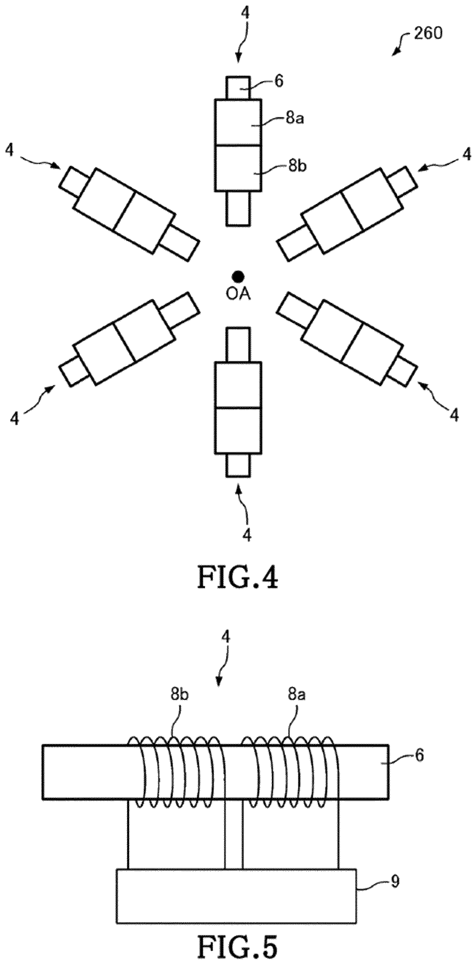

The multipole elements 260 are next described. FIG. 4 schematically shows the configuration of each multipole element 260. It is herein assumed that the multipole element 260 has six magnetic polepieces. The number of the magnetic polepieces of the multipole element 260 can be appropriately varied according to the symmetry of the generated magnetic fields.

As shown in FIG. 4, the multipole element 260 has the six magnetic polepieces 4 which are disposed radially with respect to an optical axis OA. In the multipole element 260, a hexapolar field of three-fold symmetry is produced by imparting alternately opposite polarities to the magnetic polepieces 4.

Each magnetic polepiece 4 includes a magnetic core 6, a first coil 8a, and a second coil 8b. The magnetic core 6 is a metallic rodlike member as made of a soft magnetic material. Each of the six magnetic cores 6 making up the multipole element 260 is wrapped with the first coil 8a and the second coil 8b. Therefore, the multipolar field created by the multipole element 260 by energization of the first coil 8a and the multipolar field created by the multipole element 260 by energization of the second coil 8b have the same symmetry. In the illustrated example, the multipolar field created by the multipole element 260 by energization of the first coil 8a is a hexapolar field of three-fold symmetry. Similarly, the multipolar field created by the multipole element 260 by energization of the second coil 8b is a hexapolar field of three-fold symmetry.

FIG. 5 schematically illustrates one magnetic polepiece 4. The first coil 8a is wound on the magnetic core 6. The second coil 8b is also wound on the magnetic core 6. In the example of FIGS. 4 and 5, the first coil 8a is disposed near the rear end of the magnetic polepiece 4, while the second coil 8b is disposed near the front end of the polepiece 4. Alternatively, the first coil 8a and the second coil 8b may be located near the front end and the rear end, respectively, of the magnetic polepiece 4 in a manner not illustrated. The first coil 8a and the second coil 8b are supplied with energization currents from a power supply 9.

The power supply 9 supplies the energization currents, which can be different in polarity or sense, for example, to the first coil 8a and the second coil 8b. Furthermore, the power supply 9 can supply different amounts of energization current to the first coil 8a and the second coil 8b. The power supply 9 is under control of the controller 60.

The first coil 8a and the second coil 8b are wound in the same sense. Therefore, by energizing the first coil 8a and the second coil 8b with energization currents of the same polarity, the first coil 8a and the second coil 8b produce magnetic fields of the same sense. Furthermore, by energizing the first coil 8a and the second coil 8b with energization currents of different polarities, the first coil 8a and the second coil 8b generate magnetic fields of opposite senses.

The first coil 8a and the second coil 8b may be wound in opposite senses in a manner not illustrated. In this case, by energizing the first coil 8a and the second coil 8b with energization currents of the same polarity, the first coil 8a and the second coil 8b develop magnetic fields having opposite senses. Furthermore, by energizing the first coil 8a and the second coil 8b with energization currents of different polarities, the first coil 8a and the second coil 8b generate magnetic fields having the same sense.

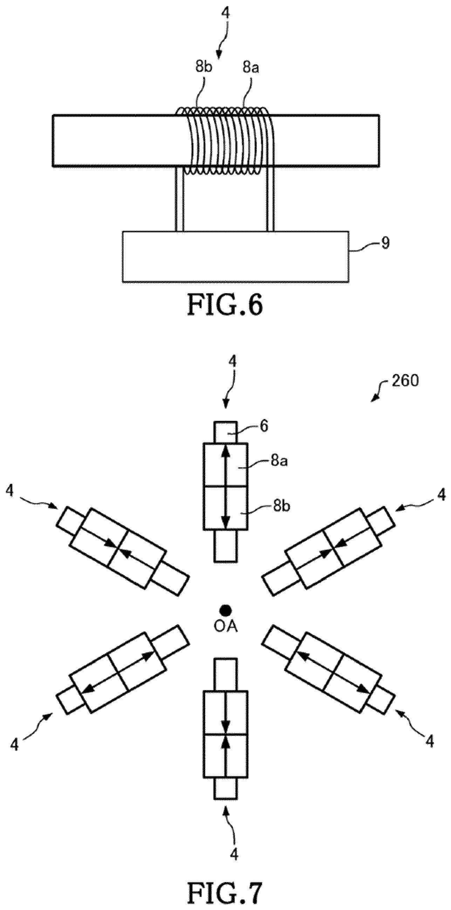

FIG. 6 shows a modification of the magnetic polepiece 4 of FIG. 5. As shown, the first coil 8a and the second coil 8b may be arranged to overlap each other. In this case, nonuniformities in the amount of heat among the coil positions can be reduced.

### 2.2. Operation of Multipole Element

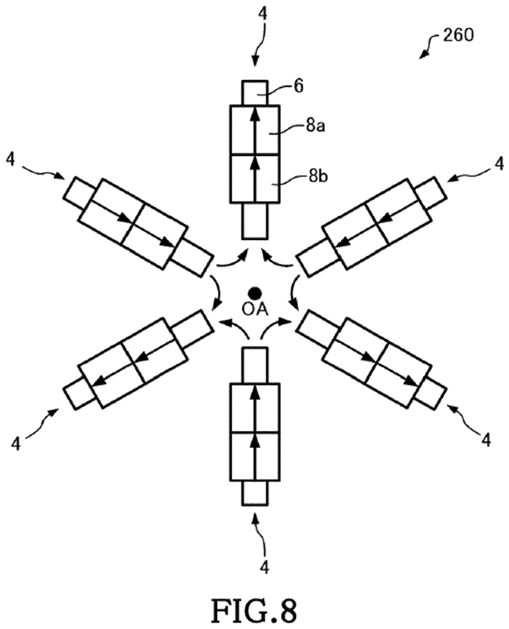

FIGS. 7 and 8 illustrate the operation of each multipole element 260. In these two figures, the arrow on each first coil 8a represents the sense of a magnetic field produced by the first coil 8a. The arrow on each second coil 8b indicates the sense of a magnetic field produced by the second coil 8b.

The multipole element 260 can have an inoperative mode in which the multipole element 260 produces no multipolar field as shown in FIG. 7 and an operative mode in which the multipole element 260 produces a multipolar field as shown in FIG. 8.

In the inoperative mode shown in FIG. 7, for each of the six magnetic polepieces 4, the magnetic field produced by the first coil 8a and the magnetic field produced by the second coil 8b are opposite in sense. Therefore, in the multipole element 260, the hexapolar field produced by energizing the first coil 8a and the hexapolar field produced by energizing the second coil 8b are opposite in sense.

For each of the six magnetic polepieces 4, the magnetic fields produced respectively by the first coil 8a and the second coil 8b are identical in strength. Therefore, in the multipole element 260, the hexapolar fields produced respectively by energizing the first coil 8a and the second coil 8b cancel out each other. Consequently, the multipole element 260 gives rise to no hexapolar field.

If the first coil 8a and the second coil 8b are equal in number of turns per unit length, the hexapolar fields produced respectively by energizing the first coil 8a and the second coil 8b can be made equal in strength by making equal to each other the amounts of energization current respectively supplied to the first coil 8a and the second coil 8b.

The first coil 8a and the second coil 8b may be different in the number of turns per unit length. In this case, the amount of energization current supplied to the first coil 8a and the amount of energization current supplied to the second coil 8b may be so adjusted that the hexapolar fields produced respectively by energizing the first coil 8a and the second coil 8b are equal in strength.

In the operative mode shown in FIG. 8, for each of the six magnetic polepieces 4, the magnetic fields respectively produced by the first coil 8a and the second coil 8b are oriented in the same sense. Therefore, with the multipole element 260, the hexapolar fields produced respectively by energizing the first coil 8a and the second coil 8b are equal in sense. Thus, the hexapolar field generated by energizing the first coil 8a and the hexapolar field generated by energizing the second coil 8b combine additively. As a consequence, the multipole element 260 can produce a hexapolar field of greater strength.

In this way, the multipole element 260 can be controllably switched between the inoperative mode and the operative mode by maintaining constant the sense of the magnetic field produced by the first coil 8a while varying the sense of the magnetic field produced by the second coil 8b. This switching in the multipole element 260 may also be controlled by varying the sense of the magnetic field produced by the first coil 8a while maintaining constant the sense of the magnetic field produced by the second coil 8b in a manner not illustrated.

The sum of the electric power consumed by the first coil 8a and the electric power consumed by the second coil 8b in the inoperative mode of FIG. 7 is equal to the sum of the electric power consumed by the first coil 8a and the electric power consumed by the second coil 8b in the operative mode of FIG. 8. Therefore, if the multipole element 260 is switched between the inoperative mode and the operative mode, the amount of heat of the multipole element 260 can be kept constant.

Let P₁ be the electric power consumed by the first coil 8a and let I₁ be the energization current supplied to the first coil 8a which is assumed to have a resistance of R₁. The electric power P₁ is given by P₁ = I₁²R₁. Similarly, let I₂ be the energization current supplied to the second coil 8b and let R₂ be the resistance of the second coil 8b. The electric power P₂ consumed by the second coil 8b is given by P₂ = I₂²R₂. Switching between the inoperative mode and the operative mode of the multipole element 260 is carried out by switching the sense (polarity) of the energization current I₂ without varying either of the energization currents I₁ and I₂. Therefore, the sum of the electric powers P₁ and P₂ in the inoperative mode can be made equal to the sum of the electric powers P₁ and P₂ in the inoperative mode. In consequence, the amount of heat of the multipole element 260 can be made uniform whether it is in the inoperative or operative mode. Hence, if the multipole element 260 is switched to its operative or inoperative mode, the amount of heat of the multipole element 260 can be maintained constant.

### 3. Optical Mode

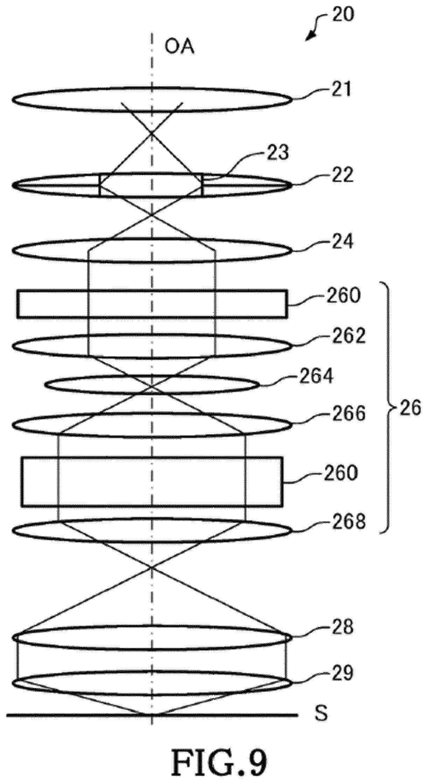

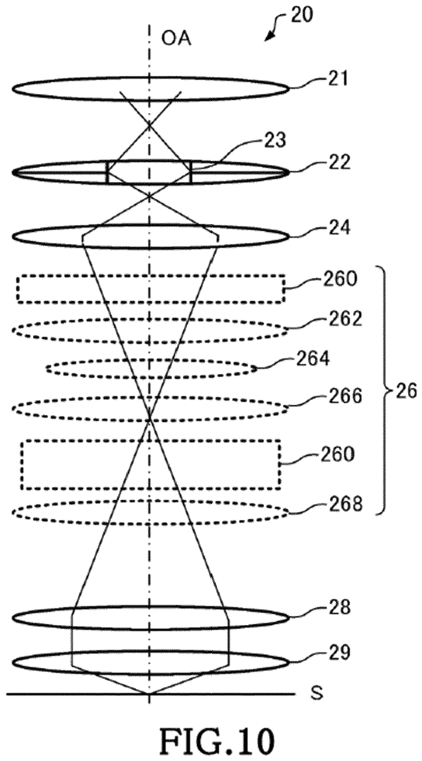

The operation of the electron microscope 100 is next described. FIGS. 9 and 10 show examples of the optical mode of the electron optical system 2. FIG. 9 illustrates a high-resolution STEM mode that is one example of the optical mode for correcting aberrations in the illumination optics 20 with the aberration corrector 26. In particular, the two stages of multipole elements 260 are each energized as shown in FIG. 8, whereby the two stages of multipole elements 260 produce their respective hexapolar fields, thus correcting aberrations in the illumination optics 20.

In the high-resolution STEM mode, the electron beam can be greatly converged into an electron probe having a large convergence angle. Consequently, a high-intensity, very fine electron probe can be obtained, and high-resolution STEM images can be derived.

In the high-resolution STEM mode, the electron beam emitted from the electron source 10 is converged into an electron probe by the illumination optics 20. The electron probe is deflected in two dimensions by the illumination optics 20. Consequently, the sample S can be scanned with the electron probe. The electron probe transmitted through the sample S is passed to the STEM detector 50 by the imaging optics 40 and detected by the STEM detector 50. An STEM image can be obtained, for example, by detecting electrons transmitted through the sample S with the STEM detector 50 in synchronism with the scanning with the electron probe. Because aberrations in the illumination optics 20 can be corrected by the aberration corrector 26, a high-resolution STEM image can be obtained.

FIG. 10 illustrates an STEM pencil beam mode that is one example of optical mode in which aberrations in the illumination optics 20 are not corrected with the aberration corrector 26. In this STEM pencil beam mode of FIG. 10, the aberration corrector 26 produces no multipolar field, and aberrations in the illumination optics 20 are not corrected. More specifically, the two stages of multipole elements 260 are placed into the inoperative mode shown in FIG. 7. As a result, each of the multipole elements 260 produces no hexapolar field. Also, none of the four collector lenses 262, 264, 266, and 268 are energized.

In the STEM pencil beam mode, small convergence angles on the order of mrad or less can be achieved. In this mode, no multipolar fields are generated; otherwise multipolar fields would induce large undesirable aberrations such as three-fold astigmatism, thus deteriorating the resolution. The STEM pencil beam mode is an optical mode suitable, for example, for the DPC (differential phase contrast) method.

In the STEM pencil beam mode, the DPC method enables acquisition of differential phase contrast (DPC) images. For example, the convergence angle of the electron beam is reduced by the illumination optics 20 operating in the STEM pencil beam mode. The sample S is scanned with the electron beam having a small convergence angle. The amounts of deflection of the electron beam at multiple points caused by the electromagnetic field within the sample S are measured, and the electromagnetic field is visualized. The deflection of the electron beam caused by the electromagnetic field within the sample S can be detected using the segmented detector 52. The detector segments D1, D2, D3, and D4 produce the detection signals I₁, I₂, I₃, and I₄, respectively. For example, the amount and direction of deflection of the electron beam caused by the electromagnetic field in the sample S can be found from the difference between the detection signals I₁ and I₃, i.e., I₁ - I₃, and from the difference between the detection signals I₂ and I₄, i.e., I₂ - I₄. A DPC image is an STEM image which is obtained by the DPC method and which provides visualization of the electromagnetic field within the sample. Note that the STEM pencil beam mode is also suitable for diffraction imaging and so on.

### 4. Control Method for Electron Microscope

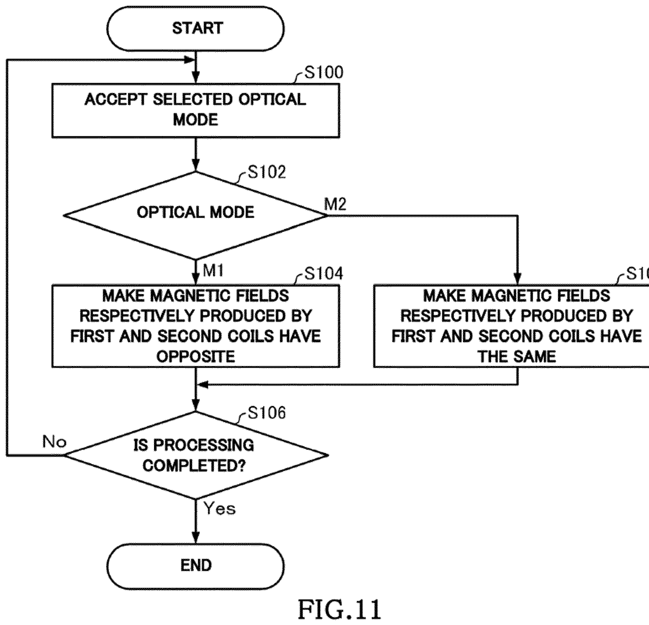

FIG. 11 is a flowchart illustrating one example of processing sequence performed by the controller 60 to control the electron optical system 2. In the following description, it is assumed that the electron optical system 2 has a first optical mode M1 in which aberrations are not corrected by the aberration corrector 26 as shown in FIG. 10 and a second optical mode M2 in which aberrations are corrected by the aberration corrector 26 as shown in FIG. 9.

The controller 60 accepts the selected optical mode for the electron optical system 2 (step S 100). More specifically, the controller 60 waits in a condition capable of accepting the selected optical mode for the electron optical system 2. For example, if the user selects either the first optical mode M1 or the second optical mode M2, the controller 60 accepts the selected optical mode. Such a selection of an optical mode is made by manipulation of an input device such as buttons, a mouse, or keys or by GUI (graphical user interface)-based manipulation.

If the first optical mode M1 is selected (M1 at step S102), the controller 60 causes the first coil 8a and the second coil 8b of the multipole element 260 to produce magnetic fields of opposite senses such that the multipole element 260 produces no multipolar field (step S 104). This can place the electron optical system 2 into the first optical mode M1.

When a switch is made from the second optical mode M2 to the first optical mode M1, the controller 60 switches both of the two stages of multipole elements 260 from the operative mode to the inoperative mode. Consequently, in the aberration corrector 26, the two stages of multipole elements 260 produce no multipolar field and thus aberrations are not corrected.

At this time, the controller 60 makes a switch from the operative to inoperative mode by reversing the polarity of the energization current supplied to the second coil 8b without varying either the amount of the energization current supplied to the first coil 8a or the amount of the energization current supplied to the second coil 8b. As a result, if the multipole element 260 is switched from the operative to inoperative mode, the amount of heat of the multipole element 260 can be kept constant.

Furthermore, the controller 60 energizes none of the four collector lenses 262, 264, 266, and 268. Consequently, the electron optical system 2 can be operated in the STEM pencil beam mode shown in FIG. 10.

After switching the optical mode of the electron optical system 2, the controller 60 makes a decision as to whether there is an instruction for ending the processing for controlling the electron optical system 2 (step S 106). The instruction for ending the processing is given by manipulation of an input device (such as buttons, a mouse, or a key) or by GUI-based manipulation.

If the controller 60 determines that there is no instruction for ending the processing (No at step S 106), control returns to step S 100, where the controller waits in a condition capable of accepting a selected optical mode of the electron optical system 2. If an optical mode is selected, the controller accepts the selected optical mode of the electron optical system 2 (step S 100).

If the second optical mode M2 is selected (M2 at step S 102), the controller 60 causes the first coil 8a and the second coil 8b of the multipole element 260 to produce magnetic fields of the same sense such that the multipole element 260 produces a multipolar field (step S 108). In consequence, the electron optical system 2 can be placed into the second optical mode M2.

When a switch is made from the first optical mode M1 to the second optical mode M2, the controller 60 switches the two stages of multipole elements 260 from the inoperative to operative mode. Consequently, in the aberration corrector 26, the two stages of multipole elements 260 produce their respective multipolar fields, correcting aberrations.

At this time, the controller 60 switches each multipole element 260 from the inoperative to operative mode by reversing the polarity of the energization current supplied to the second coil 8b without varying either of the amounts of the energization currents respectively supplied to the first coil 8a and the second coil 8b. As a result, if the multipole element 260 is switched from the inoperative to operative mode, the amount of heat of the multipole element 260 can be kept constant.

In addition, the controller 60 operates all of the four collector lenses 262, 264, 266, and 268. Consequently, the electron optical system 2 can be operated in the high-resolution STEM mode illustrated in FIG. 9.

After switching the optical mode of the electron optical system 2, the controller 60 makes a decision as to whether there is an instruction for ending the processing for controlling the electron optical system 2 (step S 106). If the controller 60 determines that there is such an instruction (Yes at step S106), the controller ends the processing for controlling the electron optical system 2.

### 3. Advantageous Effects

The electron microscope 100 includes the electron optical system 2 which has the built-in aberration corrector 26 equipped with the multipole elements 260 each for producing a multipolar field. Each multipole element 260 has the plurality of magnetic polepieces 4. Each of the polepieces 4 includes the magnetic core 6, the first coil 8a wound around the core 6, and the second coil 8b wound around the core 6. The first coil 8a and the second coil 8b produce a first multipolar field and a second multipolar field, respectively, when energized. The first and second multipolar fields are identical in terms of symmetry.

Therefore, in the electron microscope 100, the first and second multipolar fields can be canceled out by causing these multipolar fields to have opposite senses. This makes it possible to control the activation and deactivation of the multipolar field from the multipole element 260 by varying the sense of the magnetic field produced by the second coil 8b. Consequently, the amount of heat of the multipole element 260 whose multipolar field is activated and the amount of heat of the multipole element 260 whose multipolar field is deactivated can be made equal to each other.

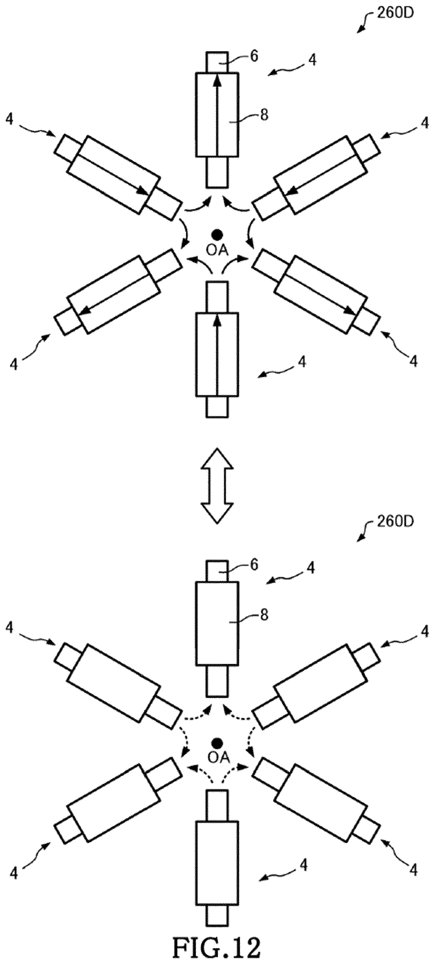

FIG. 12 illustrates the operation of a conventional multipole element 260D having magnetic cores 6. A single coil 8 is wound around each one of the magnetic cores 6. Activation and deactivation of the multipolar field from the multipole element 260D are controlled by permitting or inhibiting the supply of an energization current to the coil 8. That is, when the multipolar field is deactivated, the energization current into the coil 8 is zero. Therefore, with the multipole element 260D, the amount of heat of the coil 8 varies greatly depending on whether the multipolar field is switched on or off. Accordingly, with the multipole element 260D, aberrations will vary from when the multipolar field is switched on or off until the temperature stabilizes. Especially, when the multipolar field is switched from off to on, the amount of heat of the coil 8 increases suddenly and aberrations will vary greatly.

In contrast, in the inventive electron microscope 100, activation and deactivation of the multipolar field from the multipole element 260 can be controlled by the sense of the magnetic field produced by the second coil 8b. Therefore, the amount of heat produced by the coil while the multipolar field is activated can be made equal to the amount of heat produced by the coil while the multipolar field is deactivated. Consequently, variations in aberrations caused by switching of the multipolar field from deactivation to activation can be reduced.

Accordingly, with the electron microscope 100, even immediately after switching, for example, from the STEM pencil beam mode in which aberrations are not corrected by the aberration corrector 26 to the high-resolution STEM mode in which aberrations are corrected by the aberration corrector 26, high-resolution STEM observations are possible.

The electron microscope 100 includes the controller 60 for controlling the electron optical system 2. The controller 60 makes a switch between the inoperative mode in which each multipolar element 260 is inhibited from producing a multipolar field by causing the magnetic fields produced respectively by the first coil 8a and the second coil 8b to be oriented in opposite senses and the operative mode in which the multipolar element 260 is caused to produce a multipolar field by causing the magnetic fields produced respectively by the first coil 8a and the second coil 8b to be oriented in the same sense. Therefore, in the electron microscope 100, if the multipole element 260 is switched from the inoperative to the operative mode, the amount of heat of the multipole element 260 can be kept constant.

Furthermore, in the electron microscope 100, the controller 60 controls the energization currents respectively supplied to the first coil 8a and the second coil 8b such that the sum of the electric powers respectively consumed by the first coil 8a and the second coil 8b in the inoperative mode is equal to the sum of the electric powers respectively consumed by the first coil 8a and the second coil 8b in the operative mode. Therefore, in the electron microscope 100, if the multipole element 260 is switched from the inoperative to operative mode, the amount of heat of the multipole element 260 can be kept constant.

Further, in the electron microscope 100, the controller 60 makes a switch between the first optical mode M1 in which aberrations are not corrected by the aberration corrector 26 and the second optical mode M2 in which aberrations are corrected by the aberration corrector 26. When the electron optical system 2 is switched from the first optical mode M1 to the second optical mode M2, the controller 60 switches the multipole element 260 from its inoperative to operative mode. Therefore, in the electron microscope 100, variations of aberrations caused by the switching from the first optical mode M1 to the second optical mode M2 can be reduced.

In the electron microscope 100, the electron optical system 2 includes the illumination optics 20 for irradiating the sample S with an electron beam. The aberration corrector 26 is incorporated in the illumination optics 20. Therefore, in the electron microscope 100, variations of aberrations caused by switching between the STEM pencil beam mode (first optical mode M1) and the high-resolution STEM mode (second optical mode M2) illustrated in FIG. 9 can be reduced.

Each multipole element 260 includes the plurality of magnetic polepieces 4 for producing a multipolar field. Each of the polepieces 4 includes the magnetic core 6, the first coil 8a wound around the core 6, and the second coil 8b wound around the core 6. The first and second multipolar fields produced by energizing the first coil 8a and the second coil 8b, respectively, are identical in terms of symmetry.

Therefore, in the multipole element 260, the first and second multipolar fields can be made to cancel out each other by orienting the first and second multipolar fields oppositely to each other. Accordingly, activation and deactivation of each multipolar field can be controlled by varying the sense of the magnetic field produced by the second coil 8b. Consequently, in the multipole element 260, the amount of heat generated by the multipole element 260 during deactivation of its magnetic field can be made equal to that generated by the multipole element 260 during activation of its magnetic field.

The multipole element 260 can assume an inoperative mode and an operative mode. In the inoperative mode, no multipolar field is produced by causing magnetic fields produced respectively by the first coil 8a and the second coil 8b to be oriented in opposite senses. In the operative mode, a multipolar field is produced by causing the magnetic fields produced respectively by the first coil 8a and the second coil 8b to be oriented in the same sense. Therefore, the amount of heat from the multipole element 260 can be kept constant if it is switched either to the inoperative mode or to the operative mode.

The control method according to the present invention is for use in the electron microscope 100 including the electron optical system 2 having the built-in aberration corrector 26 equipped with the multipole elements 260 each for producing a multipolar field. The control method involves the steps of: operating the electron optical system 2 in the first optical mode M1 in which aberrations are not corrected by the aberration corrector 26; and making a switch from the first optical mode M1 to the second optical mode M2 in which aberrations are corrected by the aberration corrector 26 and operating the electron optical system 2. During the step of making a switch from the first optical mode M1 to the second optical mode M2, the multipole elements 260 are switched from the inoperative to operative mode.

Therefore, in the control method for the electron microscope 100, during the step of making a switch from the first optical mode M1 to the second optical mode M2, the multipole elements 260 are switched from the inoperative mode, in which each multipole element 260 is inhibited from producing a multipolar field by causing the first coil 8a and the second coil 8b to produce magnetic fields of opposite senses to the operative mode, in which the first coil 8a and the second coil 8b are caused to produce magnetic fields of the same sense such that the multipole element 260 produces a multipolar field. Consequently, variations in aberrations caused by switching from the first optical mode M1 to the second optical mode M2 can be reduced.

### 4. Modifications

### 4.1. First Modification

In the above embodiment, the STEM pencil beam mode of FIG. 10 is taken as one example of the first optical mode M1 in which aberrations are not corrected by the aberration corrector 26. Note that the first optical mode M1 is not restricted to this.

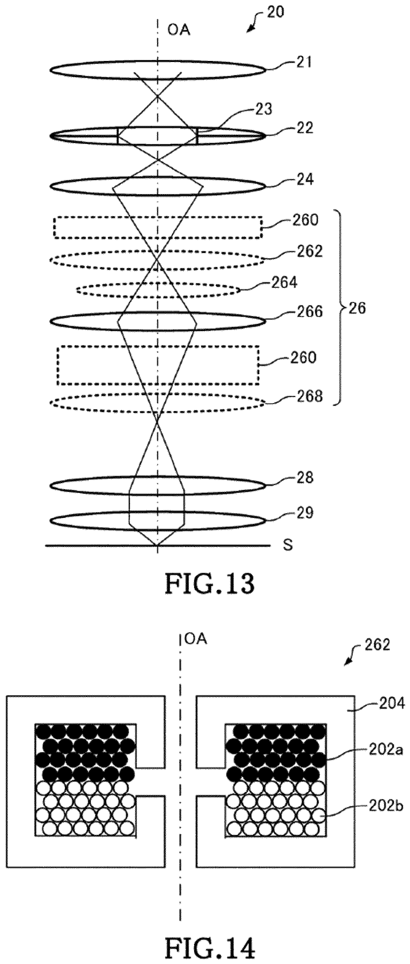

FIG. 13 illustrates a further example of the optical mode of the electron optical system 2. An STEM pencil beam mode is shown in this figure as other example of the first optical mode M1 in which aberrations are not corrected by the illumination optics 20. The STEM pencil beam mode of FIG. 13 can achieve a convergence angle of less than 1 mrad which is smaller than achieved in the STEM pencil beam mode of FIG. 10, by the use of the third collector lens 266.

The controller 60 performs the above-described control operations of FIG. 11 even when a switch is made between the STEM pencil beam mode of FIG. 13 and the high-resolution STEM mode of FIG. 9. Therefore, variations of aberrations caused by switching between these two modes can be reduced.

Another example of the first optical mode M1 is a TEM mode in which an electron beam is directed parallel to the sample S. A further example is a low-magnification mode using a final magnification of less than 3,000X. Also, in these two modes, it is desirable not to correct aberrations with the aberration corrector 26. Accordingly, when a switch is made between the TEM mode and the high-resolution STEM mode and when a switch is made between the low-magnification mode and the high-resolution STEM mode, the controller 60 performs the control operations of FIG. 11. Therefore, when a switch is made between the TEM mode and the high-resolution STEM mode and when a switch is made between the low-magnification mode and the high-resolution STEM mode, variations of aberrations due to switching of the optical mode can be reduced.

### 4.2. Second Modification

In the description of the foregoing embodiment, the multipolar field from each multipole element 260 is switched on or off while maintaining constant the amount of heat of the multipole element 260. The strength of the multipolar field produced by the multipole element 260 may be varied while maintaining constant the amount of heat of the multipole element 260.

The controller 60 varies the strength of the multipolar field produced by each multipole element 260 by varying the ratio of the energization current supplied to the second coil 8b to the energization current supplied to the first coil 8a. By varying the ratio of the energization current I₂ supplied to the second coil 8b to the energization current I₁ supplied to the first coil 8a, i.e., I₂/I₁, the ratio of the strength of the second multipolar field produced by the second coil 8b to the strength of the first multipolar field produced by the first coil 8a varies, thus varying the strength of the mulipolar field generated by the multipole element 260. At this time, the first magnetic field and the second magnetic field produced respectively by the energization of the first coil 8a and the second coil 8b are oriented in opposite senses. Consequently, the first and second multipolar fields can be made to weaken each other. Furthermore, if the ratio I₂/I₁ is varied, the sum of the electric power consumed by the first coil 8a and the electric power consumed by the second coil 8b is held constant. Consequently, the amount of heat of the multipole element 260 can be maintained constant if the multipolar field generated by the multipole element 260 is varied in strength.

For example, the controller 60 varies the strength of the multipolar field produced by the multipole element 260 from a first strength to a second strength different from the first strength by varying the ratio of the energization current I₂ supplied to the second coil 8b to the energization current I₁ supplied to the first coil 8a. At this time, the controller 60 controls the energization currents supplied respectively to the first coil 8a and the second coil 8b such that the sum of the electric power consumed by the first coil 8a and the electric power consumed by the second coil 8b when each multipole element 260 is made to produce a multipolar field of the first strength is equal to the sum of the electric power consumed by the first coil 8a and the electric power consumed by the second coil 8b when each multipole element 260 is made to produce a multipolar field of the second strength. As a consequence, if the strength of the multipolar field produced by the multipole element 260 is varied from the first strength to the second strength, the amount of heat can be maintained constant.

### 4.3. Third Modification

The foregoing embodiment is a scanning transmission electron microscope having the illumination optics 20 in which the aberration corrector 26 including the multipole elements 260 is incorporated. Another embodiment may be a transmission electron microscope (TEM) having the imaging optics 40 in which the aberration corrector 26 including the multipole elements 260 is incorporated. Incorporating the aberration corrector 26 into the imaging optics 40 permits correction of aberrations in the imaging optics 40. Two aberration correctors of the same design as the aberration corrector 26 may be prepared and incorporated respectively in the illumination optics 20 and the imaging optics 40. The electron microscope 100 may also be a scanning electron microscope (SEM) having an electron optical system equipped with the built-in aberration corrector 26.

### 4.4. Fourth Modification

In the description of the foregoing embodiment, the multipolar field from each multipole element 260 is switched on and off while maintaining constant of the amount of heat of the multipole element 260. Similarly, the magnetic field from each collector lens may be switched on and off while maintaining constant the amount of heat of the collector lens.

FIG. 14 schematically illustrates the first collector lens 262. The first collector lens 262 includes a first coil 202a, a second coil 202b, and a yoke 204. The first coil 202a and the second coil 202b are covered with the yoke 204 that is made of a ferromagnetic material such as iron. The first coil 202a is wound about an optical axis OA. Also, the second coil 202b is wound about the optical axis OA. The first coil 202a and the second coil 202b are wound in the same sense, for example.

The first coil 202a and the second coil 202b produce a first magnetic field and a second magnetic field, respectively, on the optical axis OA. The first and second magnetic fields together form a lens magnetic field.

While the first and second magnetic fields are of equal strength, the controller 60 switches off the lens magnetic field by orienting the first and second magnetic fields in opposite senses. The controller 60 switches on the lens magnetic field by orienting the first and second magnetic fields in the same sense.

The controller 60 makes the sum of the electric powers consumed respectively by the first coil 202a and the second coil 202b when the lens magnetic field is deactivated equal to the sum of the electric powers consumed respectively by the first coil 202a and the second coil 202b when the lens magnetic field is activated. This makes it possible to maintain constant the amount of heat generated by the first collector lens 262 if the lens magnetic field is switched on or off.

Although the first collector lens 262 has been described above, the other three collector lenses 264, 266, and 268 constituting the aberration corrector 26 are configured similarly. If the lens magnetic field is switched on or off, the amount of heat can be kept constant.

Accordingly, in the electron microscope 100 associated with the fourth modification, if a switch is made from the first optical mode M1 in which aberrations are not corrected with the aberration corrector 26 as shown in FIG. 10 to the second optical mode M2 in which the aberrations are corrected with the aberration corrector 26 as shown in FIG. 9, the amount of heat generated by the two stages of multipole elements 260 and the four collector lenses 262, 264, 266, 268 constituting the aberration corrector 26 can be maintained constant. Consequently, the aberration corrector 26 of high thermal stability can be accomplished.

In the same manner as in the foregoing second modification, each multipole element 260 is so designed that the amount of heat of each element 260 is constant if the strength of the multipolar field is varied.

Furthermore, each of the four collector lenses 262, 264, 266, and 268 constituting the aberration corrector 26 may be designed to produce a constant amount of heat if the lens magnetic field is varied, in the same manner as the multipole elements 260.

For example, when the ratio of the energization current supplied to the second coil 202b to the energization current supplied to the first coil 202a is varied, the ratio of the strength of the magnetic field produced by the second coil 202b to the strength of the magnetic field produced by the first coil 202a changes, thus varying the strength of the lens magnetic field. At this time, the magnetic field produced by energization of the first coil 202a and the magnetic field produced by energization of the second coil 202b are made opposite in sense to each other so that these two magnetic fields weaken each other. Furthermore, if the ratio of the energization current supplied to the second coil 202b to the energization current supplied to the first coil 202a is varied, the sum of the electric powers respectively consumed by the first coil 202a and the second coil 202b is kept constant. Consequently, if the strength of the lens magnetic field generated by the first collector lens 262 is varied, the amount of heat of this lens 262 can be maintained constant.

In the foregoing description of the first collector lens 262, the other three collector lenses 264, 266, and 268 making up the aberration corrector 26 are configured similarly. If the strength of the lens magnetic field is varied, the amount of heat can be retained constant.

In the electron microscope 100 associated with the fourth modification, the amount of heat can be maintained constant if the multipolar field from the aberration corrector 26 is switched on or off, if the strength of the multipolar field is varied, or if the strength of the lens magnetic field is varied. Hence, a thermally stable aberration corrector can be accomplished.

### 4.5. Fifth Modification

In the description of the foregoing embodiment, the multipole elements 260 are used in an aberration corrector. The multipole elements 260 may also be used in other apparatus. For example, the multipole elements 260 may be used either in a monochromator for monochromating an electron beam or in an energy filter for selecting only electrons having energies in a certain range of energies from electrons emitted from a sample. By using the multipole elements 260 in an instrument such as a monochromator or an energy filter, a thermally stable instrument can be accomplished.

Note that the above embodiments and modifications are merely exemplary and that the present invention is not restricted thereto. For example, the embodiments and modifications can be appropriately combined.

It is to be understood that the present invention is not restricted to the foregoing embodiments but rather can be implemented in various modified forms. For example, the present invention embraces configurations (e.g., configurations identical in function or method) which are substantially identical to the configurations described in the above embodiments. Furthermore, the invention embraces configurations which are similar to the configurations described in the above embodiments except that their nonessential portions have been replaced. Further, the invention embraces configurations which are similar to the configurations described in the above embodiments except that a well-known technique is added.

## Claims

1. An electron microscope comprising:
an electron optical system having a built-in aberration corrector equipped with multipole elements each for producing a multipolar field;
each of said multipole elements including a plurality of magnetic polepieces, each of the magnetic polepieces including a magnetic core, a first coil wound around the core, and a second coil wound around the core;
wherein said first coil and said second coil produce a first multipolar field and a second multipolar field, respectively, when energized; and
wherein the first and second multipolar fields are identical in terms of symmetry.

2. An electron microscope as set forth in claim 1, further comprising a controller for controlling said electron optical system,
wherein the controller makes a switch between an inoperative mode in which magnetic fields produced respectively by said first coil and said second coil are oriented in opposite senses and the multipole elements are inhibited from producing multipolar fields and an operative mode in which the magnetic fields produced respectively by said first coil and said second coil are oriented in the same sense such that the multipole elements produce multipolar fields.

3. An electron microscope as set forth in claim 2, wherein said controller controls an energization current supplied to said first coil and an energization current supplied to said second coil such that the sum of electric power consumed by the first coil and electric power consumed by the second coil in said inoperative mode is equal to the sum of electric power consumed by the first coil and electric power consumed by the second coil in said operative mode.

4. An electron microscope as set forth in any one of claims 2 and 3, wherein said controller makes a switch between a first optical mode in which aberrations are not corrected by said aberration corrector and a second optical mode in which the aberrations are corrected by the aberration corrector, and wherein the controller switches the multipole elements from said inoperative mode to said operative mode when said electron optical system is switched from the first optical mode to the second optical mode.

5. An electron microscope as set forth in claim 1, further comprising a controller for controlling said electron optical system, and wherein the controller varies the ratio of an energization current supplied to said second coil to an energization current supplied to said first coil, thereby varying the strength of each of the multipolar fields produced by said multipole elements from a first strength to a second strength different from the first strength.

6. An electron microscope as set forth in claim 5, wherein said controller controls the energization currents supplied respectively to said first coil and said second coil such that the sum of electric power consumed by the first coil and electric power consumed by the second coil when said multipole elements produce multipolar fields of said first strength is equal to the sum of electric power consumed by the first coil and electric power consumed by the second coil when said multipole elements produce multipolar fields of said second strength.

7. An electron microscope as set forth in any one of claims 1 to 6, wherein said electron optical system includes illumination optics for irradiating a sample with an electron beam, and wherein said aberration corrector is incorporated in the illumination optics.

8. An electron microscope as set forth in any one of claims 1 to 7, wherein said electron optical system includes imaging optics for imaging an electron beam transmitted through a sample, and wherein said aberration corrector is incorporated in the imaging optics.

9. A multipole element comprising a plurality of magnetic polepieces for producing a multipolar field;
wherein each of the magnetic polepieces includes a magnetic core, a first coil wound around the core, and a second coil wound around the core; and
wherein the first and second coils produce a first multipolar field and a second multipolar field, respectively, when energized, the first and second multipolar fields being identical in terms of symmetry.

10. A multipole element as set forth in claim 9, wherein the multipole element has an inoperative mode in which magnetic fields produced respectively by said first and second coils are oriented in opposite senses and no multipolar field is produced and an operative mode in which the magnetic fields produced respectively by said first and second coils are oriented in the same sense and a multipolar field is produced.

11. A control method for an electron microscope including an electron optical system having a built-in aberration corrector equipped with multipole elements each for producing a multipolar field, said control method comprising the steps of:
operating the electron optical system in a first optical mode in which aberrations are not corrected by the aberration corrector; and
making a switch from the first optical mode to a second optical mode in which the aberrations are corrected by the aberration corrector and operating the electron optical system;
each of said multipole elements including a plurality of magnetic polepieces, each of the magnetic polepieces including a magnetic core, a first coil wound around the core, and a second coil wound around the core, the first coil and the second coil operating to produce a first multipolar field and a second multipolar field, respectively, when energized, the first and second multipolar fields being identical in terms of symmetry;
each of said multipole elements having an inoperative mode in which magnetic fields produced respectively by the first coil and the second coil are oriented in opposite senses such that no multipolar field is produced and an operative mode in which the magnetic fields produced respectively by the first coil and the second coil are oriented in the same sense such that a multipolar field is produced;
wherein in the step of making a switch from the first optical mode to the second optical mode, the multipole elements are switched from the inoperative mode to the operative mode.
